**Europäisches Patentamt**

**European Patent Office**

**Office européen des brevets**

(19)

(11) Publication number : **0 427 717 B1**

# EUROPEAN PATENT SPECIFICATION

(12)

(45) Date of publication of patent specification :
**22.11.95 Bulletin 95/47**

(51) Int. Cl.⁶ : **H03L 7/10**

(21) Application number : **88907322.7**

(22) Date of filing : **04.08.88**

(86) International application number :
**PCT/FI88/00124**

(87) International publication number :
**WO 90/01834 22.02.90 Gazette 90/05**

(54) **PHASE-LOCKED LOOP CIRCUIT.**

(43) Date of publication of application :
**22.05.91 Bulletin 91/21**

(45) Publication of the grant of the patent :
**22.11.95 Bulletin 95/47**

(84) Designated Contracting States :
**AT BE CH DE FR GB IT LI LU NL SE**

(56) References cited :
**GB-A- 2 132 430
US-A- 4 156 855
US-A- 4 546 330
US-A- 4 590 440
PATENT ABSTRACT OF JAPAN, Vol 9, No
305(E-363), Abstract of JP 60-142624,published
27 July 1985.**

(56) References cited :
**PATENT ABSTRACT OF JAPAN, Vol. 9, No
277(E-355) Abstract of JP 60-120620,published
28 June 1985.
PATENT ABSTRACT OF JAPAN, Vol. 8, No
235(E-275 Abstract of JP 59-115623,Published
4 July 1984.**

(73) Proprietor : **NOKIA MOBILE PHONES LTD.
P.O. Box 86
SF-24101 Salo (FI)**

(72) Inventor : **NIEMIÖ, Mika, Erik
Ruuhikoskenkatu 10 A 8
SF-24240 Salo (FI)**

(74) Representative : **Strehl Schübel-Hopf Groening
& Partner
Maximilianstrasse 54
D-80538 München (DE)**

# Description

The present invention relates to a phase-locked loop circuit comprising in sequential connection a digital phase comparator, to one input of which a reference frequency is supplied, a loop filter and a voltage-controlled oscillator, from which a feedback branch is connected to the second input of the phase comparator.

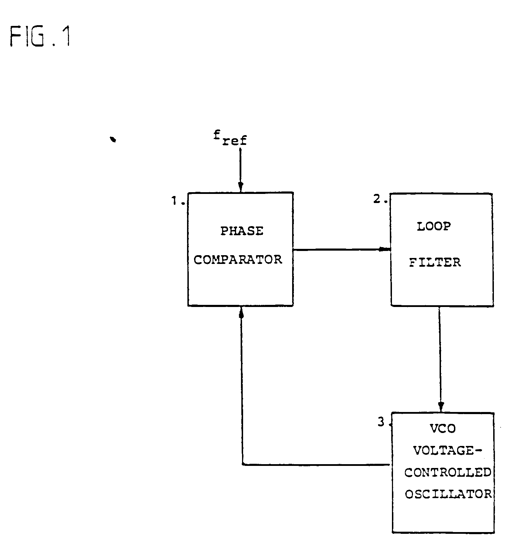

Such a phase-locked loop is presented as a block diagram in figure 1. In the figure, the reference frequency fref is applied to the input of the phase comparator 1. The output of the phase comparator 1 is connected to the loop filter 2 and the output of the loop filter 2 to the voltage-controlled oscillator 3. The output of the oscillator 3 is fed back to the phase comparator 1 so as to provide a loop that is set according to the reference frequency fref at a certain rate.

It is well known to use such a phase-locked loop for instance in frequency synthesizers. When a phase-locked loop is used in a frequency synthesizer, the voltage-controlled oscillator (VCO) of which is frequency modulated, contradictory requirements arise as to the loop bandwidth. A rapid lock is desired when switching from one channel to another, thus requiring the loop bandwidth to be as high as possible. On the other hand, for the loop not to accentuate nor to damp the modulation, its bandwidth should be low, more precisely, the loop bandwidth should be far lower than the lowest modulation frequency. A low loop bandwidth has the additional advantage of reducing the residual modulation and of increasing the damping of the phase reference frequency.

The US patent specifications 4 482 869 and 4 516 083, for instance, and the EP patent application 85615 disclose an acceleration of the loop filter by changing the resistance value of the integrator stage of the filter either by removing resistors or by short circuiting. Correspondingly, the retardation is based on a removal of the short-circuits or an addition of resistors. In the US patent specification 4 156 855 the loop is additionally accelerated by increasing the current feeding the capacitor of the integrator stage by means of a current pump.

Controlling the resistors by means of connectors, however, disturbs the operation of the loop. Thus, at the moment of connecting a slow loop, a momentary disturbance usually appears in the adjusting voltage obtained from the VCO, which is inadmissible for instance in radiotelephone applications. The same happens in the case of a sudden change of the current charging the integrator.

Consequently, frequency synthesis using a phase-locked loop has been impossible to achieve without disturbances in cases where, on the one hand, a rapid setting time, and on the other hand, a linear modulation frequency response are required. In cases where modulated frequency synthesis using a phase-locked loop has been implemented, there have been compromises between the locking time, the linearity of the modulation frequency response and the reference frequency damping.

For example, in radiotelephone applications requiring a short locking time and a linear modulation frequncy response, it has been necessary to use a so-called transfer oscillator system, in which a modulated fixed transfer oscillator frequency is mixed with the receiver injection frequency. On the other hand, a transfer oscillator has the drawback of producing a great number of mixing results, which are difficult to damp. Another drawback is a complicated and expensive circuit.

The object of the present invention is to reduce the above problems and to provide a circuit that makes possible modulated frequency synthesis when both a rapid locking time and a low loop bandwidth are required.

JP-A-60-142624 describes a phase-locked loop circuit in which a DC amplifier is provided between the phase comparator and the low-pass filter. A controller controls the VCO sensitivity and the amplifier gain, in dependence upon the output of the phase comparator.

US-A-4-590,440 describes a phase-locked loop circuit which includes means for eliminating harmonic frequency locking. The output of the VCO is monitored to determine whether it falls within a predetermined frequency range, and a limiter circuit applies, if necessary, a DC correction voltage to the VCO control input.

The present invention is defined by claim 1. The features of the preamble of claim 1 are known from US-A-4,590,440.

The invention is based on a solution involving a modification of the gain of a phase-locked loop by adjusting the voltage of the pulses obtained from the digital phase comparator, which enables the use of a high bandwidth i.e. a rapid loop during locking and a low bandwidth after the loop is locked. Since the transfer oscillator system is not used, no detrimental mixing results are produced.

When modifying the gain of the phase-locked loop in this manner by changing the voltage of the pulses obtained from the digital phase comparator, the change of the gain does not disturb the operation of the loop.

Moreover, the circuit is simple and is appropriate for a commonly used two-output digital phase comparator and an integrator of the operational amplifier type. The circuit according to the invention allows a stepless adjustment when desired, and the adjustment functions flawlessly even with small phase differences.

According to the invention, the voltage of the pulses obtained from a digital phase comparator can consequently be changed in the phase comparator or outside the phase comparator for instance by a diode, transistor, FET or some other circuit limiting the voltage. The pulse voltage limitation can be provided for instance either at the output of the phase comparator or by means of a circuit set up before the loop filter. In the phase comparator, the adjustment is feasible e.g. by changing the supply voltage of the phase comparator itself, or of its output stage.

It is essential that by changing the pulse voltage in the circuit, the gain of the phase-locked loop can be influenced, and thus the bandwidth and the locking rate of the loop, among others, can be modified.

It is also essential that when changing the loop gain in this manner by modifying the voltage of the pulses obtained from the phase comparator, the change of the gain does not disturb the operation of the loop. In addition, the gain is steplessly adjustable.

Thus, it is possible to employ a high bandwidth i.e. a rapid loop during locking and to reduce the bandwidth after the loop is locked without disturbing the operation of the loop.

In this way, a rapid setting time and a linear modulation frequency response, a small residual modulation and a great damping of the reference frequency are achieved.

The circuit of the invention for adjusting the gain of a phase-locked loop is applicable to several phase-lock applications, such as frequency-synthesis, modulator or demodulator applications (e.g. AM, FM, PM), a tracking filter, the regeneration of a clock signal, etc.

The adjustment of a phase-locked loop gain is usable in various applications, e.g. adjustment of the loop bandwidth, acceleration and retardation of the loop, linearization of the modulation frequency response, increasing the reference frequency damping, or e.g. compensating the change of the loop gain as the divisor changes.

The circuit has the additional advantage of being simple and economical, of providing a controllable adjustment, a stepless adjustment, and that the gain adjustment does not disturb the operation of the loop.

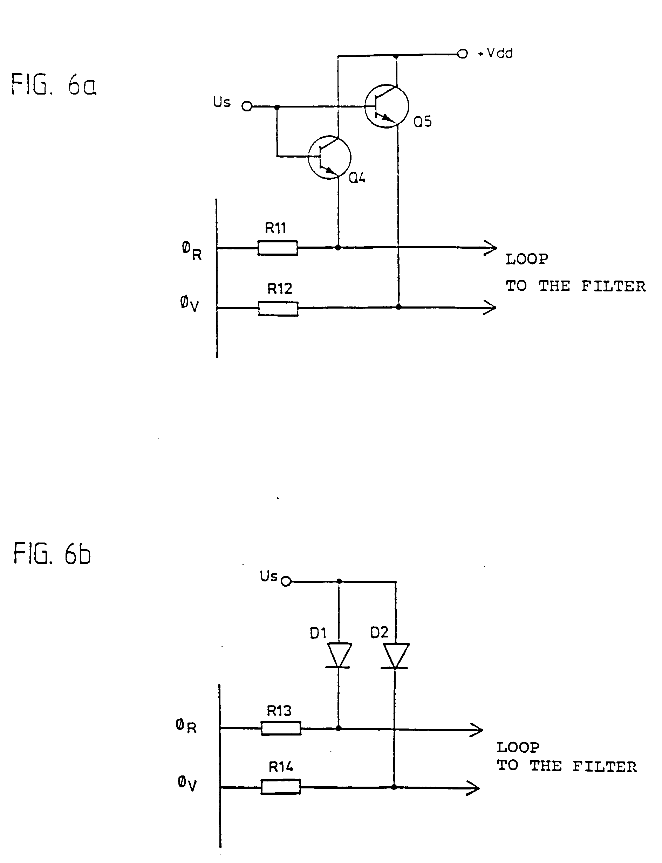

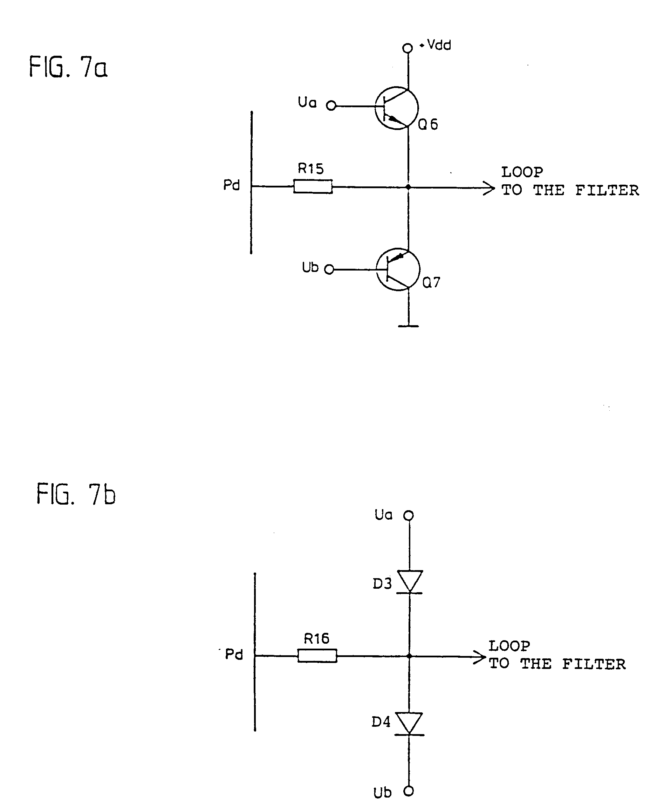

Moreover, the circuit is applicable to digital phase detectors of various types, for instance single-ended output (figures 7a, 7b) or double-ended output (figures 6a, 6b) phase detectors.

The application of the invention to a FM modulated frequency-syntheziser is described in detail below as an example and with reference to the enclosed drawings, in which :

figure 1 shows a block diagram of the known phase-locked loop described above;
figure 2 shows a block diagram of a frequency synthesizer comprising a phase-locked loop;
figure 3 shows an embodiment of the circuit according to the invention;
figure 4 shows pulses relating to the circuit of figure 3;
figure 5 shows frequency responses relating to the circuit of figure 3;
figure 6 shows embodiments relating to a double-ended output phase detector; and
figure 7 shows embodiments relating to a single-ended output phase detector.

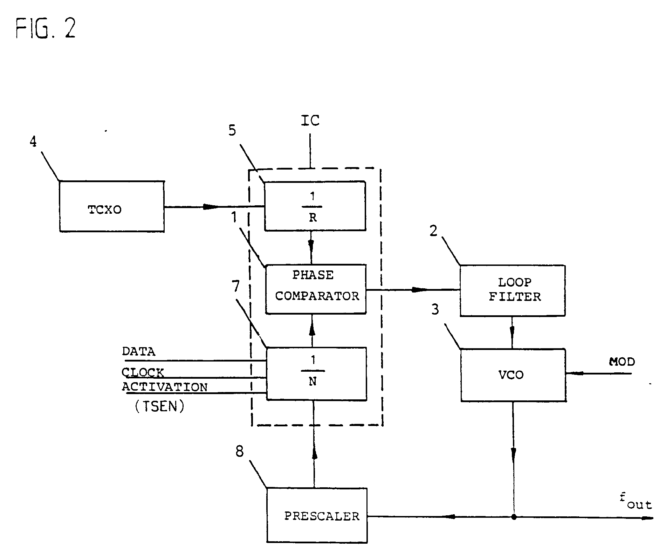

In the frequency syntheziser of figure 2 the reference frequency is provided by a stable crystal oscillator 4 (TCXO) the frequency of which is divided (by number R) by the dividing element 5 in order to generate an appropriate phase comparative frequency. The phase comparative frequency obtained is directed to the phase comparator 1, and the signal supplied by its output is fed into the loop filter 2. This loop filter is a filter of the low-pass type, in which the high frequency components are filtered from the output signal of the phase comparator, and applies a direct-current voltage to the control input of the voltage-controlled oscillator 3 (VCO). From the output of the voltage-controlled oscillator 3 the feedback is taken through the prescaler 6 and the division element 7 to the second input of the phase comparator 1. When the frequency divider 7 of the feedback loop (divisor N) is made programmable, a plurality of frequencies can be synthesised by changing the divisor N. The prescaler 6 is used to reduce the frequency of the voltage-controlled oscillator 3 to the operation range of the programmable divisor 7, the frequency range of which is usually relatively narrow. The output of the voltage-controlled oscillator 3 simultaneously forms the output of the syntheziser ($f_{out}$). Since this arrangement is well known in principle to a person skilled in the art, it will not be described in detail here. Finished integrated circuits are available today, which comprise e.g. the dividing element 5, the phase comparator 1 and the programmable divider 7, such a circuit being marked by the reference IC in the figure.

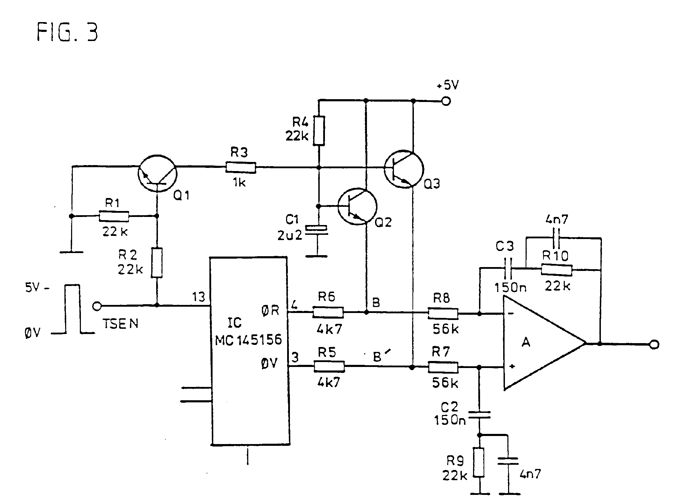

Figure 3 represents a circuit according to the invention, in which the above integrated circuit IC is of the type MC145156 (manufacturer Motorola).

This is consequently a double-ended output phase comparator, the outputs of which are marked by $\phi$V and $\phi$R in figure 3. These outputs are taken through the resistors R5 and R6 to the integrator, which in the case of the figure is realized by means of the differential amplifier A.

The natural oscillation frequency fn of the phase-locked loop is

$$fn \approx \frac{1}{2\pi} \sqrt{\frac{K\phi \cdot Kvco}{N \cdot C \cdot R}} \quad (1)$$

in which
K$\phi$ is the gain of the phase comparator,
Kvco is

$$\frac{2\pi \cdot \Delta fvco}{\Delta Vvco}, \quad (2)$$

N is the total divisor (fout/fref),
C is approx. C2=C3 in the figure 3, and
R is approx. R7=R8 in the figure 3.
By changing K$\phi$

$$fn2 = \sqrt{\frac{K\phi2}{K\phi1}} \cdot fn1 \quad (3)$$

is obtained. In other words, the natural oscillation frequency of the loop is directly proportional to the square root of the gain of the phase comparator.

In the described case the voltage of the pulses obtained from the outputs $\phi V$ and $\phi R$ of the phase comparator is influenced as follows:

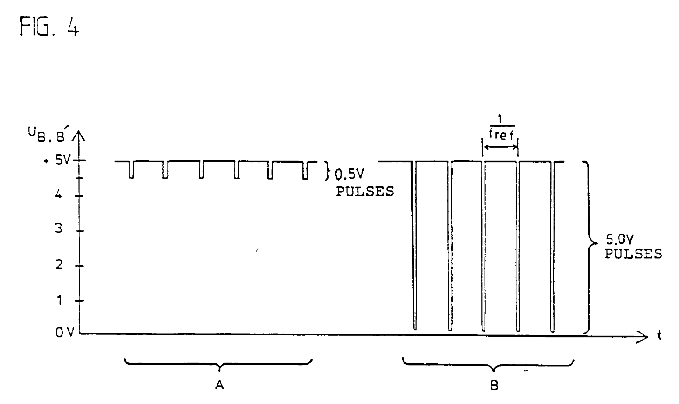

In both outputs, subsequent to the resistor R5 vs. R6 the emitters of the limiting transistors Q3 vs. Q2 are connected and the collectors of the transistors are connected to the supply voltage Vdd (5V). In a normal situation, a low limiting frequency, i.e. a slow loop is switched on, the capacitor C1 having then been charged through the resistor R4 to +5V and the transistors Q2 and Q3 limiting the 5V voltage pulses of the outputs $\phi V$ and $\phi R$ into pulses of approx. 0.5V, as indicated at section A of figure 4.

At the moment of channel switching, as the divisor information fed into the programmable divider of the circuit in use is activated, the activating pulse (TSEN) fed into the terminal 13 of the microcircuit also provides a control through the resistor R2 to the base of the switch transistor Q1. Q1 then becomes momentarily conductive and the charge of the capacitor C1 is discharged through the resistor R3. Under these circumstances, the base voltage of the transistors Q2 and Q3 decreases to ca. 0V and the height of the pulses on the emitters of the transistors rises momentarily to 5V, as indicated at section B of figure 4.

Owing to the increased loop gain, the bandwidth and rate of the loop also increase. Sustaining the rapid loop, i.e. the high gain, depends on the time constant determined by the capacitor C1. In the described case the rapid loop remains switched on for ca. 5 ms, which is enough for the loop to settle.

The natural oscillation frequency (fn1) of the described phase-locked loop with the described circuit being ca. 80 Hz with a rapid loop, the natural oscillation frequency (fn2) of a slow loop is approx. 0.5/5 x 80 Hz, i.e. ca. 25 Hz. (K$\phi$1 . Kvco/N = 2300 Hz).

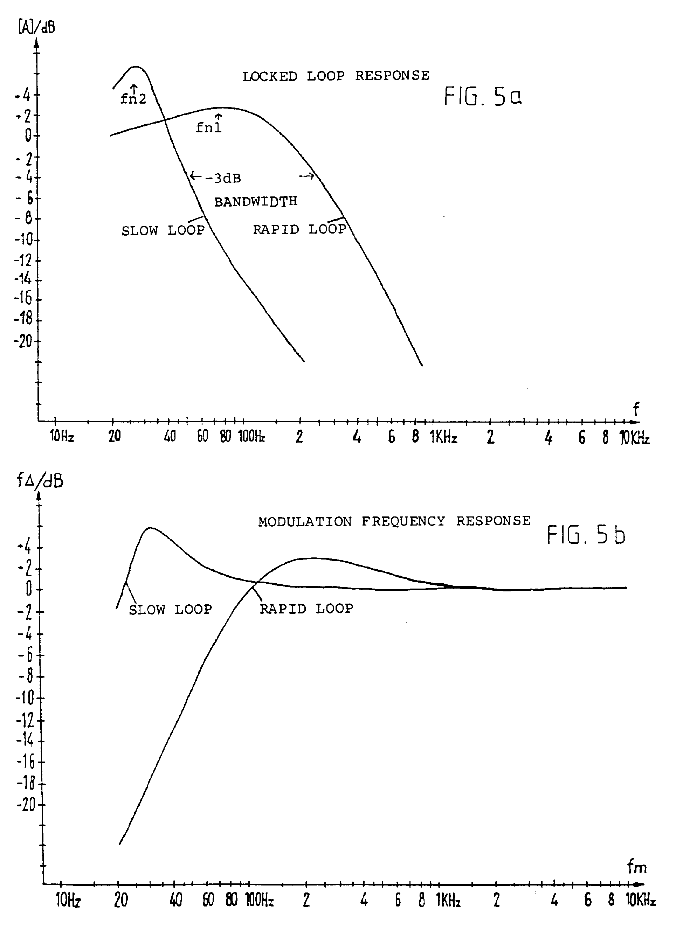

The set of curves of figure 5 illustrates the response of the locked loop of a sample circuit with a rapid loop as well as with a slow one. From the response drawn in figure 5a both the natural oscillation frequency fn and the -3dB bandwidth of the locked loop -3 dB are readable. Moreover, the modulation frequency response of this loop has been drawn in figure 5b both with a rapid and with a slow loop. The modulation frequency response remains directly within the desired range 300 Hz to 10 kHz.

Figures 6a and 6b show external limiting circuits for limiting the output of a double-ended output phase comparator. Figure 6a shows a transistor limiter having two transistors Q4, Q5, each having its emitter connected to a resistor R11, R12. Each resistor is connected to a respective output $\phi R$, $\phi V$ of the phase comparator. Each transistor's collector is connected to the supply voltage Vdd. Thus, by varying the base voltage Us of the transistors, the emitter voltages will vary so as to regulate the output to the loop filter.

Figure 6b shows a diode limiter for a double-ended output phase comparator. A first diode D1 has its cathode connected to a resistor R13 which, in turn, is connected to an output $\phi R$ of the phase comparator. A second diode D2 has its cathode connected to a resistor R14 which, in turn, is connected to the second output $\phi V$ of the phase comparator. By varying the voltage Us applied to the anodes of the diodes , the diode outputs regulate the output applied to the loop filter.

Figures 7a and 7b show external limiting circuits for limiting the output of a single-ended output phase comparator. Figure 7a shows a transistor limiter having two emitter-coupled transistors, wherein the emitters are both connected to a resistor R15 which, in turn, is connected to the output Pd of the phase comparator. One transistor Q6 is an NPN transistor having its collector connected to the supply voltage Vdd, and a second PNP transistor Q7 has its collector connected to ground. Thus, by varying the voltage Ua, Ub applied to the base of each transistor, the emitter voltages of the transistors are varied, thus modifying the voltage supplied to the loop filter.

Figure 7b shows a diode limiter controlling a single-ended output phase comparator. This circuit comprises two diodes D3, D4. The first diode D3 has its cathode connected to the anode of the second diode D4 and a resistor R16. The resistor is connected to the output Pd of the phase comparator. By regulating the voltage Ua applied to the anode of D3 and the voltage Ub applied to the cathode of D4, the output applied to the loop filter may be adjusted.

## Claims

1. A phase-locked loop circuit comprising a digital phase comparator (1), to a first input of which a reference frequency ($f_{ref}$) is supplied, a loop filter (2) which receives a pulse voltage output of the phase comparator (1), a voltage-controlled oscillator (3) which receives an output of the loop filter (2), and a feedback branch connecting the output of the oscillator (3) to the second input of the phase comparator (1),

characterised by limiting means (Q2, Q3) directly connected to the digital phase comparator (1) and limiting the amplitude of said pulse voltage output of the phase comparator (1) in response to an external input signal (TSEN) applied to the limiting means, said external input signal determines the bandwidth and locking rate of the phase-locked loop.

2. A phase-locked loop circuit according to claim 1, wherein the limiting means is provided in said phase comparator (1).

3.  A phase-locked loop circuit according to claim 1, wherein the limiting means is provided by a limiting circuit external to said phase comparator (1).

4.  A phase-locked loop circuit according to claim 3, wherein the limiting circuit comprises a transistor limiter (Q2, Q3; Q4, Q5; Q6, Q7).

5.  A phase-locked loop circuit according to claim 3, wherein the limiting circuit comprises a diode limiter (D1, D2; D3, D4).

6.  A phase-locked loop circuit according to any preceding claim, wherein the limiting means operates to modify the loop bandwidth so as to be larger during locking and smaller after locking, of the loop.

7.  A phase-locked loop circuit according to any preceding claim, wherein the limiting means operates to modify the gain and the bandwidth of the loop while the loop is locked.

8.  A phase-locked loop circuit according to claim 3 or any claim dependent thereon, wherein the pulse voltage output of the phase comparator (1) is adjustable by controlling a voltage supplied to the limiting circuit.

9.  A phase-locked loop circuit according to claim 4, wherein the phase comparator has two outputs ($\phi$R, $\phi$V), and said limiting circuit comprises two transistors (Q4, Q5), each transistor having its emitter connected through a respective resistance (R11, R12) to a separate phase comparator output, and each transistor having its collector connected to a supply voltage, whereby a change in voltage (Us) applied to the base of each transistor regulates an output of the emitter of each transistor, thus adjusting the phase comparator output voltages.

10. A phase-locked loop circuit according to claim 5, wherein the phase comparator has two outputs ($\phi$R, $\phi$V), and said limiting circuit comprises two diodes (D1, D2), each diode having its cathode connected through a respective resistance (R13, R14) to a separate phase comparator output, whereby a change in voltage (Us) applied to the anode of each diode regulates an output of the cathode of each diode, thus adjusting the phase comparator output voltages.

11. A phase-locked loop circuit according to claim 4, wherein the phase comparator has one output (Pd), and said limiting circuit comprises a first transistor (Q6) and a second transistor (Q7), the emitters of both transistors being connected together through a resistance (R15) to the phase comparator output, the first transistor (Q6) being an NPN transistor and having its collector connected to a supply voltage, the second transistor (Q7) being a PNP transistor and having its collector connected to a ground potential, whereby a change in voltage (Ua, Ub) applied to the base of each transistor regulates an output of the emitter of each transistor, thus adjusting the phase comparator output voltage.

12. A phase-locked loop circuit according to claim 5, wherein the phase comparator has one output (Pd), and said limiting circuit comprises a first diode (D3) and a second diode (D4), the cathode of the first diode (D3) and the anode of the second diode (D4) being connected together through a resistance (R16) to the phase comparator output, whereby a change in voltage (Ua, Ub) applied to the anode of the first diode and the cathode of the second diode regulates the voltage at the connection point of the first and second diodes, thus adjusting the phase comparator output voltage.

**Patentansprüche**

1.  Phasenregelkreis mit einem digitalen Phasenkomparator (1), an dessen erstem Eingang eine Bezugsfrequenz ($f_{ref}$) anliegt, mit einem Schleifenfilter (2), der das Impulsspannungs-Ausgangssignal des Phasenkomparators (1) zugeführt erhält, mit einem spannungsgesteuerten Oszillator (3), der das Ausgangssignal des Schleifenfilters (2) zugeführt erhält, und mit einem Rückkoppelzweig, der den Ausgang des Oszillators (3) mit dem zweiten Eingang des Phasenkomparators (1) verbindet,

    **gekennzeichnet** durch eine Begrenzungseinrichtung (Q2, Q3), die direkt mit dem digitalen Phasenkomparator (1) verbunden ist und die die Amplitude des Impulsspannungs-Ausgangssignals des Phasenkomparators (1) in Reaktion auf ein externes Eingangssignal (TSEN) begrenzt, das an der Begrenzungseinrichtung anliegt, wobei das externe Eingangssignal die Bandbreite und die Ankoppelgeschwindigkeit des Phasenregelkreises bestimmt.

2.  Phasenregelkreis nach Anspruch 1, wobei die Begrenzungseinrichtung im Phasenkomparator (1) vorgesehen ist.

3.  Phasenregelkreis nach Anspruch 1, wobei die Begrenzungseinrichtung eine bezüglich des Phasenkomparators (1) externe Begrenzungsschaltung ist.

4. Phasenregelkreis nach Anspruch 3, wobei die Begrenzungsschaltung einen Transistorbegrenzer (Q2, Q3; Q4, Q5; Q6, Q7) umfaßt.

5. Phasenregelkreis nach Anspruch 3, wobei die Begrenzungsschaltung einen Diodenbegrenzer (D1, D2; D3, D4) umfaßt.

6. Phasenregelkreis nach einem der vorstehenden Ansprüche, wobei die Begrenzungseinrichtung die Schleifen-Bandbreite so modifiziert, daß sie beim Ankoppeln größer und nach dem Ankoppeln der Schleife kleiner ist.

7. Phasenregelkreis nach einem der vorstehenden Ansprüche, wobei die Begrenzungseinrichtung die Verstärkung und die Bandbreite der Schleife modifiziert, während die Schleife angekoppelt ist.

8. Phasenregelkreis nach Anspruch 3 oder einem der davon abhängigen Ansprüche, wobei die vom Phasenkomparator (1) ausgegebene Impulsspannung durch Steuern einer der Begrenzungsschaltung zugeführten Spannung einstellbar ist.

9. Phasenregelkreis nach Anspruch 4, wobei der Phasenkomparator zwei Ausgänge (∅R, ∅V) und die Begrenzungsschaltung zwei Transistoren (Q4, Q5) umfaßt, wobei die Emitter der Transistoren jeweils über einen Widerstand (R11, R12) mit einem separaten Ausgang des Phasenkomparators verbunden sind und die Kollektoren der Transistoren an eine Versorgungsspannung angeschlossen sind, wodurch eine Änderung der an die Basen der Transistoren angelegten Spannung (Us) das Ausgangssignal an den Emittern der Transistoren steuert und so die Ausgangsspannung des Phasenkomparators einstellt.

10. Phasenregelkreis nach Anspruch 5, wobei der Phasenkomparator zwei Ausgänge (∅R, ∅V) und die Begrenzungsschaltung zwei Dioden (D1, D2) umfaßt, wobei die Kathoden der Dioden jeweils über einen Widerstand (R13, R14) mit einem separaten Ausgang des Phasenkomparators verbunden sind, wodurch eine Änderung der an die Anoden der Dioden angelegten Spannung (Us) das Ausgangssignal an den Kathoden der Dioden steuert und so die Ausgangsspannung des Phasenkomparators einstellt.

11. Phasenregelkreis nach Anspruch 4, wobei der Phasenkomparator einen Ausgang (Pd) hat und die Begrenzungsschaltung einen ersten Transistor (Q6) und einen zweiten Transistoren (Q7) umfaßt, wobei die Emitter beider Transistoren zusammen über einen Widerstand (R15) mit dem Ausgang des Phasenkomparators verbunden sind und der erste Transistor (Q6) ein NPN-Transistor, dessen Kollektor an eine Versorgungsspannung angeschlossen ist, und der zweite Transistor (Q7) ein PNP-Transistor ist, dessen Kollektor an Masse angeschlossen ist, wodurch eine Änderung der an die Basen der Transistoren angelegten Spannungen (Ua, Ub) das Ausgangssignal an den Emittern der Transistoren steuert und so die Ausgangsspannung des Phasenkomparators einstellt.

12. Phasenregelkreis nach Anspruch 5, wobei der Phasenkomparator einen Ausgang (Pd) hat und die Begrenzungsschaltung eine erste Diode (D3) und eine zweite Diode (D4) umfaßt, wobei die Kathode der ersten Diode (D3) und die Anode der zweiten Diode (D4) zusammen über einen Widerstand (R16) mit dem Ausgang des Phasenkomparators verbunden sind, wodurch eine Änderung der an die Anode der ersten Diode und die Kathode der zweiten Diode angelegten Spannungen (Ua, Ub) die Spannung am Verbindungspunkt der ersten und zweiten Diode steuert und so die Ausgangsspannung des Phasenkomparators einstellt.

**Revendications**

1. Circuit à boucle à verrouillage de phase comprenant un comparateur de phase numérique (1), sur une première entrée duquel une fréquence de référence (fref) est appliquée, un filtre de boucle (2) lequel reçoit une sortie de tension d'impulsion du comparateur de phase (1), un oscillateur commandé en tension (3) lequel reçoit une sortie du filtre de boucle (2), et une dérivation de contre-réaction reliant la sortie de l'oscillateur (3) à la seconde entrée du comparateur de phase (1),
caractérisé par un moyen de limitation (Q2, Q3) directement relié au comparateur de phase numérique (1) et limitant l'amplitude de ladite sortie de tension d'impulsion du comparateur de phase (1) en réponse à un signal d'entrée externe (TSEN) appliqué au moyen de limitation, ledit signal d'entrée externe déterminant la largeur de bande et la cadence de verrouillage de la boucle à verrouillage de phase.

2. Circuit à boucle à verrouillage de phase selon la revendication 1, dans lequel le moyen de limitation est procuré dans ledit comparateur de phase (1).

3. Circuit à boucle à verrouillage de phase selon la revendication 1, dans lequel le moyen de limitation est procuré par un circuit de limitation externe audit comparateur de phase (1).

4. Circuit à boucle à verrouillage de phase selon la revendication 3, dans lequel le circuit de limitation comprend un limiteur à transistors (Q2, Q3 ; Q4, Q5 ; Q6, Q7).

5. Circuit à boucle à verrouillage de phase selon la revendication 3, dans lequel le circuit de limitation comprend un limiteur à diodes (D1, D2 ; D3, D4).

6. Circuit à boucle à verrouillage de phase selon l'une quelconque des revendications précédentes, dans lequel le moyen de limitation fonctionne de façon à modifier la largeur de bande de la boucle de telle sorte qu'elle soit plus grande pendant le verrouillage et plus petite après le verrouillage de la boucle.

7. Circuit à boucle à verrouillage de phase selon l'une quelconque des revendications précédentes, dans lequel le moyen de limitation fonctionne de façon à modifier le gain et la largeur de bande de la boucle pendant que la boucle est verrouillée.

8. Circuit à boucle à verrouillage de phase selon la revendication 3 ou l'une quelconque des revendications dépendant de celle-ci, dans lequel la sortie de tension d'impulsion du comparateur de phase (1) est réglable en commandant une tension appliquée au circuit de limitation.

9. Circuit à boucle à verrouillage de phase selon la revendication 4, dans lequel le comparateur de phase comporte deux sorties (0R, 0V), et ledit circuit de limitation comprend deux transistors (Q4, Q5), chaque transistor ayant son émetteur relié par l'intermédiaire d'une résistance respective (R11, R12) à une sortie de comparateur de phase séparée, et chaque transistor ayant son collecteur relié à une tension d'alimentation, d'où il résulte qu'une variation de la tension (Us) appliquée à la base de chaque transistor régule une sortie de l'émetteur de chaque transistor, réglant ainsi les tensions de sortie du comparateur de phase.

10. Circuit à boucle à verrouillage de phase selon la revendication 5, dans lequel le comparateur de phase comporte deux sorties (0R, 0V), et ledit circuit de limitation comprend deux diodes (D1, D2), chaque diode ayant sa cathode reliée par l'intermédiaire d'une résistance respective (R13, R14) à une sortie de comparateur de phase séparée, d'où il résulte qu'une modification de la tension (Us) appliquée à l'anode de chaque diode régule une sortie de la cathode de chaque diode, réglant ainsi les tensions de sortie du comparateur de phase.

11. Circuit à boucle à verrouillage de phase selon la revendication 4, dans lequel le comparateur de phase comporte une sortie (Pd), et ledit circuit de limitation comprend un premier transistor (Q6) et un second transistor (Q7), les émetteurs des deux transistors étant reliés ensemble par l'intermédiaire d'une résistance (R15) à la sortie du comparateur de phase, le premier transistor (Q6) étant un transistor NPN et ayant son collecteur relié à une tension d'alimentation, le second transistor (Q7) étant un transistor PNP et ayant son collecteur relié à un potentiel de masse, d'où il résulte qu'une modification de la tension (Ua, Ub) appliquée à la base de chaque transistor régule une sortie de l'émetteur de chaque transistor, réglant ainsi la tension de sortie du comparateur de phase.

12. Circuit à boucle à verrouillage de phase selon la revendication 5, dans lequel le comparateur de phase comporte une sortie (Pd), et ledit circuit de limitation comprend une première diode (D3) et une seconde diode (D4), la cathode de la première diode (D3) et l'anode de la seconde diode (D4) étant reliées ensemble par l'intermédiaire d'une résistance (R16) à la sortie du comparateur de phase, d'où il résulte qu'une modification de la tension (Ua, Ub) appliquée à l'anode de la première diode et à la cathode de la seconde diode régule la tension au point de jonction des première et seconde diodes, réglant ainsi la tension de sortie du comparateur de phase.

# FIG.1

FIG. 2

FIG. 3

FIG. 4

[A]/dB

LOCKED LOOP RESPONSE

FIG. 5a

fn2

fn1

←−3dB

BANDWIDTH

SLOW LOOP          RAPID LOOP

f

10Hz    20    40    60 80 100Hz    2    4    6  8 1KHz    2    4    6  8 10KHz

fΔ/dB

MODULATION FREQUENCY RESPONSE

FIG. 5b

SLOW LOOP          RAPID LOOP

fm

10Hz    20    40    60 80 100Hz    2    4    6  8 1KHz    2    4    6  8 10KHz

12

FIG. 6a

LOOP
TO THE FILTER

FIG. 6b

LOOP
TO THE FILTER

13

FIG. 7a

FIG. 7b

14